# FASCICULE DE BREVET EUROPEEN

(11) **EP 4 055 634 B1**
(45) Date de publication et mention de la délivrance du brevet: **18.10.2023**
(21) Numéro de dépôt: 20828662.5
(22) Date de dépôt: 30.11.2020
(51) Int. Cl.: H01L 31/048, H01L 31/18

(54) **PROCÉDÉ DE FABRICATION D'UN MODULE PHOTOVOLTAÏQUE AVEC RÉTICULATION PARTIELLE ET LAMINATION**
VERFAHREN ZUR HERSTELLUNG EINES FOTOVOLTAIKMODULS MIT PARTIELLER VERNETZUNG UND KASCHIERUNG
METHOD FOR MANUFACTURING A PHOTOVOLTAIC MODULE WITH PARTIAL CROSSLINKING AND LAMINATION

(30) Priorité: 16.12.2019 FR 1914469
(43) Date de publication de la demande: 14.09.2022
(73) Titulaire: Commissariat à l'Energie Atomique et aux Energies Alternatives, 75015 Paris (FR)
(72) Inventeur: MANEVAL, Victor, 38054 GRENOBLE Cedex 09 (FR); CHABUEL, Fabien, 38054 GRENOBLE Cedex 09 (FR); GAUME, Julien, 38054 GRENOBLE Cedex 09 (FR); ROUJOL, Yannick, 38054 GRENOBLE Cedex 09 (FR)
(74) Mandataire: Brevalex
(86) Numéro de dépôt international: PCT/FR2020/052221
(87) Numéro de publication internationale: WO 2021/123535

(56) Documents cités:
- EP-A2- 2 166 576
- DE-A1-102011 005 378
- JP-A- 2013 235 932
- US-A1- 2010 126 560
- US-A1- 2010 147 363
- CH. HIRSCHL ET AL: "Determining the degree of crosslinking of ethylene vinyl acetate photovoltaic module encapsulants-A comparative study", SOLAR ENERGY MATERIALS AND SOLAR CELLS, vol. 116, 1 septembre 2013 (2013-09-01), pages 203-218, XP055210546, ISSN: 0927-0248, DOI: 10.1016/j.solmat.2013.04.022

## Description

### DOMAINE TECHNIQUE

La présente invention se rapporte au domaine des modules photovoltaïques, qui comportent un ensemble de cellules photovoltaïques reliées entre elles électriquement.

Plus spécifiquement, l'invention concerne le domaine des modules photovoltaïques utilisés pour des applications spatiales, mais aussi pour des applications terrestres. De tels modules photovoltaïques peuvent être flexibles ou rigides.

L'invention propose ainsi un procédé de fabrication d'un module photovoltaïque avec des étapes de réticulation partielle et de lamination.

### ÉTAT DE LA TECHNIQUE ANTÉRIEURE

Afin de préserver les cellules photovoltaïques d'un module photovoltaïque, il est classique de les encapsuler. L'encapsulation des cellules photovoltaïques permet de les protéger de l'environnement extérieur, comme par exemple de la pluie, du vent, de la neige, de l'humidité, des rayonnements ultraviolets, des radiations, entre autres.

Pour cela, il est connu de former un empilement comportant successivement: un élément de protection arrière, un premier film d'encapsulant, classiquement d'éthylène acétate de vinyle (EVA), des cellules photovoltaïques reliées électriquement entre elles, un deuxième film d'encapsulant, classiquement d'éthylène acétate de vinyle (EVA), un élément de protection avant transparent comme par exemple une plaque de verre.

L'élément de protection avant est destiné à recevoir le rayonnement solaire avant que ce dernier ne coopère avec les cellules photovoltaïques pour générer de l'énergie électrique. Cet empilement est ensuite laminé à chaud pour faire fondre les films en EVA et provoquer la réticulation de l'EVA fondu, d'où il résulte la formation d'une enveloppe d'encapsulation solide des cellules photovoltaïques collée aux éléments de protection avant et arrière.

L'utilisation de l'EVA sous forme de film présente l'avantage de faciliter la fabrication d'un module photovoltaïque en utilisant une lamination réalisée à chaud de l'empilement. Il est également plus compétitif pour un usage industriel. Cependant, l'EVA présente comme inconvénient de générer de l'acide acétique lors de sa réticulation au cours de la lamination, cet acide acétique provoquant notamment l'érosion des électrodes des cellules photovoltaïques. L'EVA présente aussi l'inconvénient de jaunir dans le temps du fait de son exposition aux rayonnements ultraviolets. Par ailleurs, l'EVA présente l'inconvénient d'être associé à une gamme étroite de température d'utilisation qui rend son utilisation incompatible dans un environnement spatial. Enfin, les films d'EVA industriels sont actuellement difficilement disponibles dans des épaisseurs aussi faibles que celles souhaitées pour des applications spatiales. L'épaisseur requise est inférieure à 100 µm, quand les films disponibles industriellement font au minimum 200 µm.

Aussi, des solutions d'encapsulation à base de silicones, ou encore polysiloxanes, ont été envisagées dans l'art antérieur, notamment pour des applications spatiales et terrestres, ainsi que comme colle pour certains composants des satellites.

Par exemple, le brevet américain US 4,057,439 A décrit une solution d'encapsulation à base de silicones. L'objectif du brevet est d'améliorer l'adhésion de tels encapsulants sur les cellules solaires et les supports pour éviter des délaminations. Le problème de cette solution est qu'elle met en oeuvre une encapsulation par voie liquide pouvant générer des bulles de gaz, notamment des bulles d'air, au sein de l'encapsulant et rendant difficile la maîtrise de l'épaisseur de l'encapsulant. Le module évoluant dans le vide, les bulles de gaz peuvent provoquer l'éclatement du module photovoltaïque lorsqu'il sera déployé hors de l'atmosphère terrestre dans une application spatiale du fait d'une différence de pression entre les bulles de gaz et l'extérieur du module photovoltaïque. Pour une application terrestre, la présence des bulles est aussi néfaste car au-delà de simples problèmes d'esthétisme, les bulles peuvent induire une moins bonne transmission du rayonnement solaire vers les cellules photovoltaïques si ces bulles se sont formées au-dessus des cellules photovoltaïques (le rayonnement solaire peut alors en partie être réfléchi). Par ailleurs, les bulles peuvent aussi induire une moins bonne dissipation thermique du module photovoltaïque, pouvant ainsi engendrer instantanément une perte d'efficacité des cellules photovoltaïques. Un autre inconvénient de la présence de bulles est qu'elles peuvent favoriser à terme la délamination du module photovoltaïque.

Par ailleurs, le brevet américain US 9,842,952 B2 divulgue une autre solution d'encapsulation à base de silicones. Les cellules photovoltaïques sont d'abord déposées sur une première couche extérieure. Ensuite, une composition à base de silicone et de fibres de renfort est positionnée sur les cellules photovoltaïques afin de former une deuxième couche extérieure. L'utilisation de fibres de renfort permet de contrôler la diffusion de la composition de silicone et d'éviter le recours à une couche de support de sorte à réduire les coûts, les difficultés de production et le temps de fabrication. Cependant, l'usage de telles fibres dans la composition de silicone engendre aussi des contraintes supplémentaires par rapport à l'utilisation d'une simple composition de silicone qui ne sont pas nécessairement souhaitables, par exemple en termes de complexité supplémentaire de fabrication, de coûts plus élevés, d'éventuels problèmes d'adhérence des fibres à la composition de silicone, ou encore de diminution de la transparence de la composition de silicone, entre autres. L'ajout de fibres ou d'un autre élément dans l'encapsulant engendre généralement une masse plus importante, ce qui n'est pas souhaitable pour une application spatiale. De plus, certaines fibres comme les fibres de carbone pourraient représenter un risque de court-circuit du fait de leur conductivité électrique plus élevée.

Ainsi, l'utilisation des résines silicones seules comme matériaux d'encapsulation pour des applications spatiales est une solution à privilégier. Elles peuvent aussi être utiles pour des applications terrestres en permettant notamment d'augmenter la durée de vie des modules solaires de 25 à 40, voire 50 ans. Une telle amélioration est principalement due à l'absence de génération d'acide acétique pendant le processus de réticulation, contrairement à l'EVA, et à une meilleure stabilité thermique et aux ultraviolets. De plus, la chimie des silicones est suffisamment flexible pour pouvoir ajuster avec précision les propriétés physico-chimiques des produits, telles que l'indice de réfraction, la viscosité, la dureté et la résistance à la traction, et la production de masse de ces matériaux est possible. De plus, en raison de leur faible module de Young et de leur faible température de transition vitreuse, de l'ordre de -50°C, leurs propriétés mécaniques restent constantes sur une large gamme de températures.

Cependant, les adhésifs à base de silicone pure sont généralement initialement à l'état liquide, ce qui complique leur mise en oeuvre. En particulier, ils ne sont pas compatibles en l'état avec les procédures de lamination sous vide, contrairement aux adhésifs sous forme de films. Ainsi, bien que l'encapsulation de modules photovoltaïques avec des résines silicones ait été envisagée depuis plus de trente ans dans l'art antérieur, il subsiste de nombreux challenges à relever afin d'améliorer la fiabilité de ce type de procédé. Les principales difficultés liées à l'utilisation de silicone pour encapsuler des modules photovoltaïques sont donc : les méthodes de dépôt ; le contrôle de l'épaisseur; l'adhésion de l'ensemble des couches ; le fluage de l'encapsulant pendant un procédé de lamination ; le procédé utilisé pour la réticulation ; la durée de vie du produit une fois préparé ; la présence de bulles d'air piégées, de vides ou de cavités ; l'optimisation de la composition pour améliorer les propriétés du polymère (viscosité, élasticité, transparence et dureté) ; la production à des volumes élevés et à un coût raisonnable. Les documents JP 2013 235932 A et US 2010/126560 A1 décrivent des modules photovoltaïques comprenant une couche d'adhésion partiellement réticulée.

### EXPOSÉ DE L'INVENTION

L'invention a pour but de remédier au moins partiellement aux besoins mentionnés ci-dessus et aux inconvénients relatifs aux réalisations de l'art antérieur.

L'invention a ainsi pour objet, selon l'un de ses aspects, un procédé de fabrication d'un module photovoltaïque, comprenant au moins une cellule photovoltaïque, notamment une pluralité de cellules photovoltaïques disposées côte à côte, entre une première couche transparente formant une face avant du module photovoltaïque et une deuxième couche formant une face arrière du module photovoltaïque, caractérisé en ce qu'il comporte :
1) une première étape consistant à déposer une première couche d'adhésion à base d'un matériau polymère réticulable sur la première couche destinée à former la face avant du module photovoltaïque, et à déposer une deuxième couche d'adhésion à base d'un matériau polymère réticulable sur la deuxième couche destinée à former la face arrière du module photovoltaïque,
2) une deuxième étape consistant à réaliser une réticulation partielle, encore appelée pré-réticulation, des deux couches d'adhésion à base d'un matériau polymère réticulable pour former deux couches d'adhésion partiellement réticulées,
3) une troisième étape consistant à déposer ladite au moins une cellule photovoltaïque sur l'une des deux couches d'adhésion partiellement réticulées,
4) une quatrième étape consistant à former un empilement multicouche, à savoir un empilement des couches constitutives du module photovoltaïque, par assemblage d'une des deux couches d'adhésion partiellement réticulées sur l'autre des deux couches d'adhésion partiellement réticulées, laquelle comprend ladite au moins une cellule photovoltaïque, permettant ainsi l'encapsulation de la ou des cellules photovoltaïques,
5) une cinquième étape consistant à réaliser la lamination de l'empilement multicouche, et la finalisation de la réticulation des deux couches d'adhésion partiellement réticulées, de sorte à former une seule et unique couche d'encapsulation de la des cellules photovoltaïques.

Avantageusement, le procédé de fabrication selon l'invention permet donc de réaliser un empilement en parallèle sur la première couche formant la face avant et sur la deuxième couche formant la face arrière, de déposer la ou les cellules photovoltaïques sur l'une des deux faces, puis d'assembler les deux parties pré-réticulées, i.e. réticulées partiellement et préalablement à l'étape de lamination qui permet en général ladite réticulation, et enfin de laminer l'ensemble. De cette façon, il est possible de limiter l'inclusion d'air entre les barrières avant/arrière et l'encapsulant, à l'inverse de solutions de l'art antérieur prévoyant un empilement entièrement réalisé à partir d'une seule face. Il est également possible d'obtenir une épaisseur finale d'encapsulant adaptée, contrôlée et homogène, voire différente sur les deux faces si besoin. Cette épaisseur finale est avantageusement comprise entre 40 et 200 microns, et la position de la ou des cellules au sein de l'encapsulant final n'est pas nécessairement au milieu de cet encapsulant.

De façon avantageuse encore, l'invention permet donc de réaliser l'encapsulation de modules photovoltaïques à l'aide d'adhésifs de type silicone dont la réticulation est initiée préalablement à la lamination.

Par « matériau polymère réticulable », on entend un matériau polymère apte à être réticulé, dont l'état peut passer à un état réticulé. Un matériau polymère réticulable présente notamment un degré de réticulation strictement inférieur au point de gel de ce matériau polymère. Notamment, le matériau polymère réticulable est à l'état liquide. Par « matériau à l'état liquide », il est entendu que le matériau a tendance à couler en raison de la faible cohésion des molécules qui le compose. Notamment, l'état liquide du matériau polymère réticulable est tel que ce matériau polymère réticulable présente une viscosité préférentiellement comprise entre 1 Pa.s et 50 Pa.s à une température de 25°C. Dans la présente description, les valeurs de viscosités sont données à la pression atmosphérique.

Le procédé de fabrication selon l'invention peut en outre comporter l'une ou plusieurs des caractéristiques suivantes prises isolément ou suivant toutes combinaisons techniques possibles.

Préférentiellement, la première couche d'adhésion à base d'un matériau polymère réticulable et la deuxième couche d'adhésion à base d'un matériau polymère réticulable peuvent être identiques. En particulier, elles peuvent être à base du même matériau polymère réticulable.

Par ailleurs, la première couche d'adhésion peut être à base d'un matériau polymère réticulable à l'état liquide et/ou la deuxième couche d'adhésion peut être à base d'un matériau polymère réticulable à l'état liquide.

Chaque couche d'adhésion à base d'un matériau polymère réticulable, déposée lors de la première étape, à savoir la première couche d'adhésion et la deuxième couche d'adhésion, peut présenter une épaisseur comprise entre 20 et 100 µm, préférentiellement entre 20 et 60 µm, et avantageusement de l'ordre de 50 µm, à savoir égale à 50 µm ± 5 µm. Les première et deuxième couches d'adhésion à base d'un matériau polymère réticulable peuvent présenter des épaisseurs différentes ou identiques. L'épaisseur globale des première et deuxième couches d'adhésion à base d'un matériau polymère réticulable est avantageusement comprise entre 40 et 200 µm.

De plus, le taux de réticulation mis en oeuvre lors de la deuxième étape de réticulation partielle des deux couches d'adhésion à base d'un matériau polymère réticulable peut être compris entre 40 % et 70 %, préférentiellement entre 50 % et 60 %, préférentiellement encore entre 50 % et 55 %. Le taux de réticulation peut varier dans cette gamme, selon le matériau utilisé et selon les paramètres de lamination utilisés par la suite.

Le taux de réticulation peut être mesuré par méthode DSC (pour « Differential Scanning Calorimeter » en anglais), mesure relative par calcul de l'air sous le pic de réticulation, suivant la méthode d'enthalpie de la norme IEC 62788 adaptée à des encapsulants silicones : on réalise un balayage en température, de 40°C à 200°C, d'un échantillon frais d'encapsulant. Ce balayage fait apparaître le pic de réticulation. En calculant l'air sous le pic de la courbe, on obtient l'enthalpie de la réaction totale de réticulation, c'est-à-dire l'énergie libérée par la réaction exothermique de réticulation. Lorsque l'on réalise la même mesure et le même calcul pour un échantillon partiellement pré-réticulé, la valeur d'enthalpie est inférieure à celle du produit frais, puisqu'elle correspond à la fin de la réticulation. On parle d'enthalpie résiduelle. La différence entre les deux enthalpies nous donne le pourcentage de la réaction de réticulation effectué pendant la pré-réticulation.

Une telle valeur du taux de réticulation permet de maximiser l'adhésion entre les différentes couches, de permettre l'évacuation des bulles d'air, ainsi que de minimiser l'épaisseur finale de l'encapsulant. Cette valeur du taux de réticulation correspond ainsi au meilleur compromis entre adhésion, faible épaisseur et évacuation des bulles d'air.

En outre, la durée de réticulation mise en oeuvre lors de la deuxième étape de réticulation partielle des deux couches d'adhésion à base d'un matériau polymère réticulable peut être comprise entre 1 minute et 1 heure.

La température de réticulation mise en oeuvre lors de la deuxième étape de réticulation partielle des deux couches d'adhésion à base d'un matériau polymère réticulable peut être comprise entre 50 et 150 °C.

En particulier, la durée de réticulation mise en oeuvre lors de la deuxième étape de réticulation partielle des deux couches d'adhésion à base d'un matériau polymère réticulable peut être comprise entre 5 minutes et 15 minutes, et la température de réticulation mise en oeuvre lors de la deuxième étape de réticulation partielle des deux couches d'adhésion à base d'un matériau polymère réticulable peut être comprise entre 90 et 110 °C.

Par ailleurs, la cinquième étape de lamination peut être réalisée à une pression positive, sur le module, comprise entre 100 mbar et 1 bar, notamment entre 500 mbar et 1 bar, notamment encore entre 800 mbar et 1 bar. Aussi, la chambre où se trouve le module n'est pas nécessairement sous vide.

De plus, la cinquième étape de lamination peut comprendre une mise sous vide pendant une durée comprise entre 5 et 10 minutes.

Préférentiellement, le matériau polymère réticulable peut être choisi parmi la famille des silicones.

En outre, ladite au moins une cellule photovoltaïque peut être choisie parmi les cellules de type silicium, semi-conducteurs III-V, CIGS (cuivre, indium, gallium, sélénium), CdTe (tellurure de cadmium), organique, perovskites ou multi-jonctions de ces types, entre autres.

Par ailleurs, de façon avantageuse, la ou les couches d'adhésion à base d'un matériau polymère réticulable sont dépourvues de tout élément de renfort, notamment de toutes fibres de renfort, textiles ou non, notamment prévu pour limiter l'écoulement liquide du matériau polymère réticulable.

### BRÈVE DESCRIPTION DES DESSINS

L'invention pourra être mieux comprise à la lecture de la description détaillée qui va suivre, d'un exemple de mise en oeuvre non limitatif de celle-ci, ainsi qu'à l'examen des figures, schématiques et partielles, du dessin annexé, sur lequel :
La figure 1 illustre, schématiquement et en coupe, la première étape d'un procédé de fabrication d'un module photovoltaïque conforme à l'invention,
La figure 2 illustre, schématiquement et en coupe, la deuxième étape du procédé de fabrication conforme à l'invention,
La figure 3 illustre, schématiquement et en coupe, la troisième étape du procédé de fabrication conforme à l'invention,
La figure 4 illustre, schématiquement et en coupe, la quatrième étape du procédé de fabrication conforme à l'invention, et
La figure 5 illustre, schématiquement et en coupe, la cinquième étape du procédé de fabrication conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Dans la description de l'exemple de mise en oeuvre de l'invention qui va suivre, le domaine d'application concerné est celui des modules photovoltaïques pour des applications spatiales. Toutefois, l'invention s'applique aussi aux modules photovoltaïques prévus pour des applications terrestres.

De façon avantageuse, le procédé de fabrication selon l'invention permet l'encapsulation avec un matériau polymère réticulable en utilisant deux étapes principales consistant à réaliser une réticulation partielle de l'encapsulant liquide, et une lamination de l'ensemble de l'empilement formé.

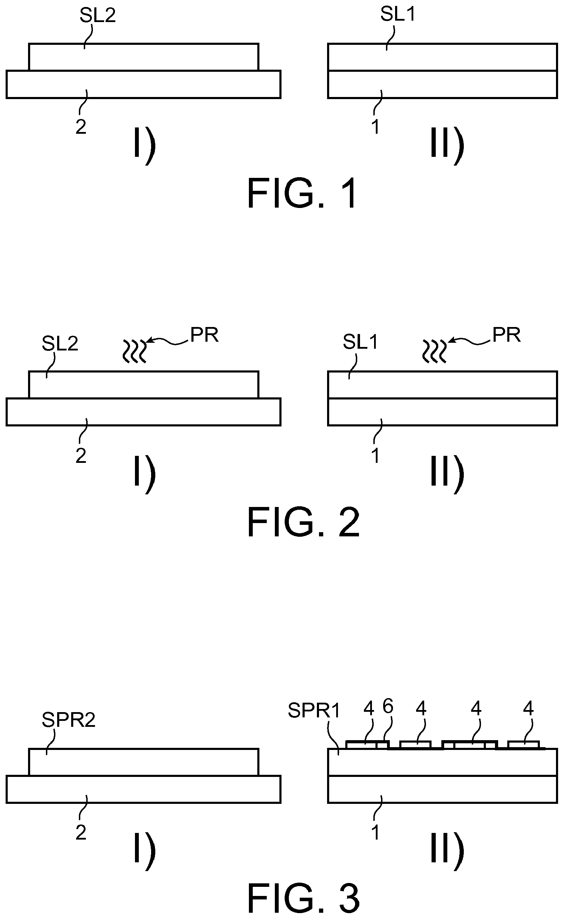

Plus particulièrement, comme illustré sur la figure 1, le procédé de fabrication d'un module photovoltaïque 10 conforme à l'invention comporte tout d'abord une première étape 1) qui consiste à former un premier sous-empilement I) et un deuxième sous-empilement II).

Le premier sous-empilement I) est formé par le dépôt d'une couche d'adhésion liquide SL2 à base d'un matériau polymère réticulable sur une deuxième couche 2 destinée à former la face arrière du module photovoltaïque 10.

Le deuxième sous-empilement II) est formé par le dépôt d'une couche d'adhésion liquide SL1 à base d'un matériau polymère réticulable sur une première couche 1 destinée à former la face avant du module photovoltaïque 10.

De façon préférentielle, le matériau polymère réticulable est choisi parmi la famille des silicones. Le silicone a l'avantage d'être transparent, isolant électriquement et présente une stabilité environnementale et thermique (c'est-à-dire pas ou peu de dégradations liées à l'humidité, à l'oxygène ou aux acides à des températures variant entre -200°C et 200°C). Par ailleurs, le silicone peut améliorer la durée de vie du module photovoltaïque 10 par rapport à un encapsulant en EVA. Le silicone évite la formation d'acide acétique, contrairement à l'EVA. Le silicone présente une meilleure stabilité aux rayonnements ultraviolets. La chimie du silicone est suffisamment flexible pour ajuster avec précision les propriétés physico-chimiques (indice de réfraction, viscosité, dureté, résistance à la traction, mécanique) de l'encapsulant tout en permettant une production en masse. En raison du faible module de Young du silicone et de la faible température de transition vitreuse (par exemple de -50°C) du silicone, les propriétés mécaniques du silicone réticulé restent constantes sur une large gamme de températures. Avec le silicone, il est possible d'encapsuler une ou plusieurs cellules photovoltaïques 4 pour une application spatiale à une température pouvant varier entre -65°C et +200°C et utilisables jusqu'à -200°C.

Ensuite, comme illustré sur la figure 2, une deuxième étape 2) est réalisée par la réticulation partielle, schématisée par PR sur la figure 2, des deux couches d'adhésion liquides SL1, SL2 pour former, sur le premier sous-empilement I), une deuxième couche d'adhésion partiellement réticulée SPR2, visible sur la figure 3, et, sur le deuxième sous-empilement II), une première couche d'adhésion partiellement réticulée SPR1, visible sur la figure 3.

La réticulation partielle PR du silicone liquide permet d'augmenter sa viscosité et sa tenue mécanique, ce qui permet alors d'assurer une quantité minimale d'encapsulant sur et sous les cellules photovoltaïques 4.

Par la suite, comme illustré sur la figure 3, une troisième étape 3) est mise en oeuvre par le dépôt des cellules photovoltaïques 4 sur la première couche d'adhésion partiellement réticulée SPR1. Alternativement, le dépôt pourrait aussi se faire sur la deuxième couche d'adhésion partiellement réticulée SPR2, autrement dit au niveau de la face arrière. Cette alternative peut être particulièrement utile lorsque la face arrière 2 comporte un circuit imprimé avec des pistes conductrices auxquelles les cellules photovoltaïques 4 doivent être reliées/connectées. Dans ce cas-là, il est possible de protéger les éléments d'interconnexion des cellules pour les rendre accessibles après la phase de réticulation partielle.

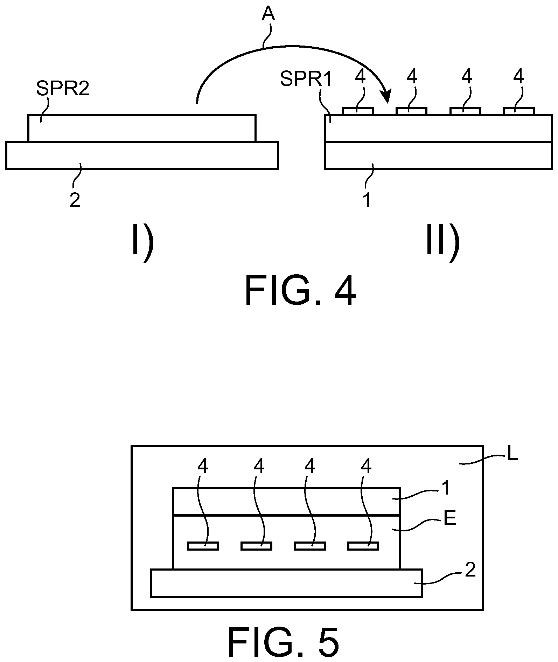

Une quatrième étape 4) est alors mise en oeuvre, comme visible sur la figure 4, consistant à former un empilement multicouche, à savoir un empilement des couches constitutives du module photovoltaïque 10, par assemblage du premier sous-empilement I) sur le deuxième sous-empilement II), schématisé par la flèche A, la deuxième couche d'adhésion partiellement réticulée SPR2, dépourvue de cellules photovoltaïques 4, venant alors au-dessus de la première couche partiellement réticulée SPR1 qui comprend les cellules photovoltaïques 4.

Alors, une cinquième étape 5), illustrée par la figure 5, permet de réaliser la lamination, schématisée par le cadre L, de l'ensemble obtenu et la finalisation de la réticulation des deux couches d'adhésion partiellement réticulées SPR1, SPR2 pour former une seule et unique couche d'encapsulation E des cellules photovoltaïques 4. Il est à noter que, avant cette étape de lamination, il est également possible de retourner l'empilement de sorte à ce que la face avant 1 soit tournée vers le bas.

Tout matériau polymère réticulable visé dans la présente description peut comporter, notamment être constitué de, deux composants A et B. Le composant A est une base, par exemple de type PDMS (pour polydiméthylsiloxane). Le composant B contient un agent vulcanisant, comme par exemple le polysiloxane, et un catalyseur pour permettre aux chaînes de polymère de se ramifier pour former un réseau tridimensionnel de sorte que le matériau polymère réticulable puisse, au terme de sa réticulation, former une couche correspondante en matériau solide et infusible.

Le matériau polymère réticulable utilisé dans le cadre du présent procédé de fabrication peut être choisi parmi : Sylgard ^{®} 184 de l'entreprise Dow Corning, Dow Corning ^{®} 93-500, Siltech ^{®} CR 12-63, Siltech ^{®} CR 13-46, Elastosil ^{®} RT 625 de l'entreprise Wacker, MAPSIL ^{®} 213 de l'entreprise MAP COATING, MAPSIL ^{®} 213B de l'entreprise MAP COATING, et MAPSIL ^{®} QS 1123 de l'entreprise MAP COATING.

Il va à présent être décrit un exemple particulier de réalisation. Dans cet exemple, on procède tout d'abord à la préparation de la face avant 1.

La surface de la face avant 1 est préparée à l'aide d'un traitement physique de surface, par exemple de type plasma ou corona, suivi d'un dépôt de primaire pour faciliter l'accroche du matériau polymère réticulable. Il est à noter que la première couche 1 formant la face avant est avantageusement transparente, et peut être du verre ou un polymère tel que du polyimide transparent, du polytéréphtalate d'éthylène (PET), du polynaphtalate d'éthylène (PEN), ou encore un film fluoré tel que du fluoroéthylène propylène (FEP), de l'éthylène tétrafluoroéthylène (ETFE), de l'éthylène chlorotrifluoroéthylène (ECTFE), du polyfluorure de vinylidène (PVDF), ou encore du polyétheréthercétone (PEEK), entre autres.

Ensuite, un dépôt d'une couche de silicone liquide SL1 est réalisé sur cette face avant 1. Cet adhésif peut être déposé par un quelconque moyen d'enduction, au pinceau, au rouleau, au dispositif dit « Doctor Blade », ou encore par spray. L'épaisseur et le moyen de dépose sont adaptés à l'utilisation. L'épaisseur est par exemple comprise entre 20 et 100 µm. Moins l'adhésif sera visqueux, plus il sera aisé de réaliser des films minces. Une quantité d'adhésif trop faible ou trop importante entraînerait l'apparition de bulles d'air ou de vides dans le module 10 lors de la réticulation.

Alors, la couche d'adhésif est dégazée dans une cloche à vide pendant une période comprise entre 1 et 20 minutes, de préférence comprise entre 5 et 10 minutes.

On réalise ensuite la réticulation partielle de cette couche d'adhésif SL1 pour obtenir la couche pré-réticulée SPR1. La réticulation partielle est réalisée avec le moyen voulu : chauffage au four ou étuve, chauffage par infrarouge ou ultraviolet, entre autres.

Ensuite, on positionne les cellules photovoltaïques 4 interconnectées, par exemple par le biais d'un ruban 6 comme visible sur la figure 3, sur la couche pré-réticulée SPR1, les cellules étant éventuellement enduites de primaire pour maximiser l'adhésion. Ces cellules 4 peuvent être à base de silicium, à base de matériaux de type III-V, CIGS (cuivre, indium, gallium, sélénium), CdTe (tellurure de cadmium), organiques, perovskites ou multi-jonctions de ces types.

En parallèle, on prépare la face arrière 2 par un procédé symétrique à celui appliqué pour la face avant 1. Il faut toutefois noter que les paramètres de réticulation partielle et les épaisseurs peuvent être ou non identiques pour la face avant 1 et la face arrière 2.

Ainsi, la surface de la face arrière 2 est préparée à l'aide d'un traitement physique de surface, par exemple de type plasma ou corona, suivi d'un dépôt de primaire pour faciliter l'accroche du matériau polymère réticulable. Cette face arrière 2 n'est pas nécessairement transparente. Elle peut être un support en matériau composite, par exemple de type carbone/nid d'abeilles en aluminium, ou une mousse, du verre, un film polymère ou encore un tissu, entre autres.

Ensuite, un dépôt d'une couche de silicone liquide SL2 est réalisé sur cette face arrière 2. Cet adhésif peut être déposé par un quelconque moyen d'enduction, au pinceau, au rouleau, au dispositif dit « Doctor Blade »ou encore par spray. L'épaisseur et le moyen de dépose sont adaptés à l'utilisation. L'épaisseur est par exemple comprise entre 20 et 100 µm. Il faut que moins l'adhésif sera visqueux, plus il sera aisé de réaliser des films minces. Une quantité d'adhésif trop faible ou trop importante entraînerait l'apparition de bulles d'air et de vides dans le module 10 lors de la réticulation.

Alors, la couche d'adhésif est dégazée dans une cloche à vide pendant une période comprise entre 1 et 20 minutes, de préférence comprise entre 5 et 10 minutes.

On réalise ensuite la réticulation partielle de cette couche d'adhésif SL2 pour obtenir la couche pré-réticulée SPR2. La réticulation partielle est réalisée avec le moyen voulu : chauffage au four ou étuve, chauffage par infrarouge ou ultraviolet, entre autres.

De préférence, la durée de l'étape de réticulation partielle est comprise entre 5 et 15 minutes, par exemple de l'ordre de 5 à 7 minutes, et la température est comprise entre 90°C et 110°C, par exemple 100°C.

A ce stade, on procède alors à l'assemblage des deux parties et à la lamination sous vide. Les deux parties I) et II) sont ainsi assemblées de manière à obtenir l'empilement des couches 1, SPR1, 4, SPR2, 2. Elles sont ensuite laminées sous vide.

Le programme de lamination comprend une étape de vide pendant 5 à 10 minutes, suivie d'une étape de chauffe durant laquelle on applique une pression positive comprise entre 100 mbar et 1 bar, préférentiellement entre 500 mbar et 1 bar, voire 800 mbar et 1 bar. La température et la durée nécessaires à la réticulation complète dépendent des caractéristiques de l'adhésif. Par exemple, pour réticuler une formulation de Sylgard^{®} 184, une lamination à 140°C comprenant 5 minutes de vide et 15 minutes à 1 bar est adaptée.

Il est à noter que, dans le cas où la différence de coefficient d'expansion thermique est élevée entre les différents matériaux, il peut être judicieux d'abaisser la température de la lamination et donc d'augmenter sa durée. Pour le Sylgard^{®} 184, une lamination à 80° avec 5 minutes de vide et 50 minutes à 1 bar est également possible. Ceci permet notamment de limiter les contraintes thermomécaniques exercées sur les différents matériaux constituant le module photovoltaïque 10 pendant la fabrication, et limiter ainsi les contraintes internes résiduelles après fabrication pouvant aller jusqu'à créer des courbures indésirables du module.

Bien entendu , l'invention est definie par la portée des revendications ci-jointes et elle n'est pas limitée à l'exemple de réalisation qui vient d'être décrit.

## Revendications

1. Procédé de fabrication d'un module photovoltaïque (10), comprenant au moins une cellule photovoltaïque (4) entre une première couche (1) transparente formant une face avant du module photovoltaïque (10) et une deuxième couche (2) formant une face arrière du module photovoltaïque (10), **caractérisé en ce qu'**il comporte :
1) une première étape consistant à déposer une première couche d'adhésion (SL1) à base d'un matériau polymère réticulable sur la première couche (1) destinée à former la face avant du module photovoltaïque (10), et à déposer une deuxième couche d'adhésion (SL2) à base d'un matériau polymère réticulable sur la deuxième couche (2) destinée à former la face arrière du module photovoltaïque (10),
2) une deuxième étape consistant à réaliser une réticulation partielle des deux couches d'adhésion (SL1, SL2) à base d'un matériau polymère réticulable pour former deux couches d'adhésion partiellement réticulées (SPR1, SPR2),
3) une troisième étape consistant à déposer ladite au moins une cellule photovoltaïque (4) sur l'une (SPR1) des deux couches d'adhésion partiellement réticulées (SPR1, SPR2),
4) une quatrième étape consistant à former un empilement multicouche (1, SPR1, 4, SPR2, 2) par assemblage d'une (SPR1) des deux couches d'adhésion partiellement réticulées (SPR1, SPR2) sur l'autre (SPR2) des deux couches d'adhésion partiellement réticulées (SPR1, SPR2), laquelle comprend ladite au moins une cellule photovoltaïque (4),
5) une cinquième étape consistant à réaliser la lamination de l'empilement multicouche (1, SPR1, 4, SPR2, 2), et la finalisation de la réticulation des deux couches d'adhésion partiellement réticulées (SPR1, SPR2),
le taux de réticulation mis en oeuvre lors de la deuxième étape de réticulation partielle des deux couches d'adhésion (SL1, SL2) à base d'un matériau polymère réticulable étant compris entre 40 % et 70 %.

2. Procédé selon la revendication 1, **caractérisé en ce que** chaque couche d'adhésion (SL1, SL2) à base d'un matériau polymère réticulable, déposée lors de la première étape, présente une épaisseur comprise entre 20 et 100 µm, préférentiellement entre 20 et 60 µm, préférentiellement encore de l'ordre de 50 µm.

3. Procédé selon la revendication 1 ou 2, **caractérisé en ce que** le taux de réticulation mis en oeuvre lors de la deuxième étape de réticulation partielle des deux couches d'adhésion (SL1, SL2) à base d'un matériau polymère réticulable est compris entre 50 % et 60 %, préférentiellement encore entre 50 % et 55 %.

4. Procédé selon l'une des revendications précédentes, **caractérisé en ce que** la durée de réticulation mise en oeuvre lors de la deuxième étape de réticulation partielle des deux couches d'adhésion (SL1, SL2) à base d'un matériau polymère réticulable est comprise entre 1 minute et 1 heure.

5. Procédé selon l'une quelconque des revendications précédentes, **caractérisé en ce que** la température de réticulation mise en oeuvre lors de la deuxième étape de réticulation partielle des deux couches d'adhésion (SL1, SL2) à base d'un matériau polymère réticulable est comprise entre 50 et 150 °C.

6. Procédé selon les revendications 4 et 5, **caractérisé en ce que** la durée de réticulation mise en oeuvre lors de la deuxième étape de réticulation partielle des deux couches d'adhésion (SL1, SL2) à base d'un matériau polymère réticulable est comprise entre 5 minutes et 15 minutes, et **en ce que** la température de réticulation mise en oeuvre lors de la deuxième étape de réticulation partielle des deux couches d'adhésion (SL1, SL2) à base d'un matériau polymère réticulable est comprise entre 90 et 110 °C.

7. Procédé selon l'une quelconque des revendications précédentes, **caractérisé en ce que** la cinquième étape de lamination est réalisée à une pression positive comprise entre 100 mbar et 1 bar, notamment entre 500 mbar et 1 bar, notamment encore entre 800 mbar et 1 bar.

8. Procédé selon l'une quelconque des revendications précédentes, **caractérisé en ce que** la cinquième étape de lamination comprend une mise sous vide pendant une durée comprise entre 5 et 10 minutes.

9. Procédé selon l'une quelconque des revendications précédentes, **caractérisé en ce que** le matériau polymère réticulable est choisi parmi la famille des silicones.

10. Procédé selon l'une quelconque des revendications précédentes, **caractérisé en ce que** ladite au moins une cellule photovoltaïque (4) peut être choisie parmi les cellules de type silicium, semi-conducteurs III-V, CIGS (cuivre, indium, gallium, sélénium), CdTe (tellurure de cadmium), organiques, perovskites ou multi-jonctions de ces types.

11. Procédé selon l'une quelconque des revendications précédentes, **caractérisé en ce que** la première couche d'adhésion (SL1) à base d'un matériau polymère réticulable et la deuxième couche d'adhésion (SL2) à base d'un matériau polymère réticulable sont à base du même matériau polymère réticulable.

12. Procédé selon l'une quelconque des revendications précédentes, **caractérisé en ce que** la première couche d'adhésion (SL1) est à base d'un matériau polymère réticulable à l'état liquide et/ou **en ce que** la deuxième couche d'adhésion (SL2) est à base d'un matériau polymère réticulable à l'état liquide.

## Patentansprüche

1. Verfahren zur Herstellung eines Photovoltaikmoduls (10), mindestens eine Photovoltaikzelle (4) umfassend zwischen einer ersten transparenten Schicht (1), die eine vordere Fläche des Photovoltaikmoduls (10) bildet, und einer zweiten Schicht (2), die eine hintere Fläche des Photovoltaikmoduls (10) bildet, **dadurch gekennzeichnet, dass** es beinhaltet:
1) einen ersten Schritt, der darin besteht, eine erste Haftschicht (SL1), auf einem vernetzbaren Polymermaterial basierend, auf die erste Schicht (1) aufzubringen, die dazu bestimmt ist, die vordere Fläche des Photovoltaikmoduls (10) zu bilden, und eine zweite Haftschicht (SL2), auf einem vernetzbaren Polymermaterial basierend, auf die zweite Schicht (2) aufzubringen, die dazu bestimmt ist, die hintere Fläche des Photovoltaikmoduls (10) zu bilden,
2) einen zweiten Schritt, der darin besteht, eine teilweise Vernetzung der zwei Haftschichten (SL1, SL2), auf einem vernetzbaren Polymermaterial basierend, durchzuführen, um zwei teilweise vernetzte Haftschichten (SPR1, SPR2) zu bilden,
3) einen dritten Schritt, der darin besteht, die mindestens eine Photovoltaikzelle (4) auf einer (SPR1) der zwei teilweise vernetzten Haftschichten (SPR1, SPR2) aufzubringen,
4) einen vierten Schritt, der darin besteht, einen mehrschichtigen Stapel (1, SPR1, 4, SPR2, 2) zu bilden durch Montage einer (SPR1) der zwei teilweise vernetzten Haftschichten (SPR1, SPR2) auf die andere (SPR2) der zwei teilweise vernetzten Haftschichten (SPR1, SPR2), die die mindestens eine Photovoltaikzelle (4) umfasst,
5) einen fünften Schritt, der darin besteht, die Laminierung des mehrschichtigen Stapels (1, SPR1, 4, SPR2, 2) durchzuführen, und die Fertigstellung der Vernetzung der zwei teilweise vernetzten Haftschichten (SPR1, SPR2),
wobei die Vernetzungsrate, die im zweiten Schritt der teilweisen Vernetzung der zwei Haftschichten (SL1, SL2), auf einem vernetzbaren Polymermaterial basierend, angewendet wird, zwischen 40 % und 70 % liegt.

2. Verfahren nach Anspruch 1, **dadurch gekennzeichnet, dass** jede Haftschicht (SL1, SL2), auf einem vernetzbaren Polymermaterial basierend, die im ersten Schritt aufgebracht wird, eine Dicke zwischen 20 und 100 µm aufweist, vorzugsweise zwischen 20 und 60 µm, noch bevorzugter in der Größenordnung von 50 µm.

3. Verfahren nach Anspruch 1 oder 2, **dadurch gekennzeichnet, dass** die Vernetzungsrate, die im zweiten Schritt der teilweisen Vernetzung der zwei Haftschichten (SL1, SL2), auf einem vernetzbaren Polymermaterial basierend, angewendet wird, zwischen 50 % und 60 % liegt, noch bevorzugter zwischen 50 % und 55 %.

4. Verfahren nach einem der vorhergehenden Ansprüche, **dadurch gekennzeichnet, dass** die Vernetzungsdauer, die im zweiten Schritt der teilweisen Vernetzung der zwei Haftschichten (SL1, SL2), auf einem vernetzbaren Polymermaterial basierend, angewendet wird, zwischen 1 Minute und 1 Stunde liegt.

5. Verfahren nach einem der vorhergehenden Ansprüche, **dadurch gekennzeichnet, dass** die Vernetzungstemperatur, die im zweiten Schritt der teilweisen Vernetzung der zwei Haftschichten (SL1, SL2), auf einem vernetzbaren Polymermaterial basierend, angewendet wird, zwischen 50 und 150 °C liegt.

6. Verfahren nach Anspruch 4 und 5, **dadurch gekennzeichnet, dass** die Vernetzungsdauer, die im zweiten Schritt der teilweisen Vernetzung der zwei Haftschichten (SL1, SL2), auf einem vernetzbaren Polymermaterial basierend, angewendet wird, zwischen 5 Minuten und 15 Minuten liegt, und dass die Vernetzungstemperatur, die im zweiten Schritt der teilweisen Vernetzung der zwei Haftschichten (SL1, SL2), auf einem vernetzbaren Polymermaterial basierend, angewendet wird, zwischen 90 und 110 °C liegt.

7. Verfahren nach einem der vorhergehenden Ansprüche, **dadurch gekennzeichnet, dass** der fünfte Schritt der Laminierung bei einem Überdruck durchgeführt wird, der zwischen 100 mbar und 1 bar liegt, insbesondere zwischen 500 mbar und 1 bar, noch geeigneter zwischen 800 mbar und 1 bar.

8. Verfahren nach einem der vorhergehenden Ansprüche, **dadurch gekennzeichnet, dass** der fünfte Schritt der Laminierung ein Vakuumieren für eine Dauer umfasst, die zwischen 5 und 10 Minuten liegt.

9. Verfahren nach einem der vorhergehenden Ansprüche, **dadurch gekennzeichnet, dass** das vernetzbare Polymermaterial aus der Familie der Silikone ausgewählt ist.

10. Verfahren nach einem der vorhergehenden Ansprüche, **dadurch gekennzeichnet, dass** die mindestens eine Photovoltaikzelle (4) aus Zellen vom Typ Silizium, III-V-Halbleiter, CIGS (Kupfer, Indium, Gallium, Selen), CdTe (Cadmiumtellurid), organisch, Perowskit oder Mehrfachverbindungen dieser Typen ausgewählt werden kann.

11. Verfahren nach einem der vorhergehenden Ansprüche, **dadurch gekennzeichnet, dass** die erste Haftschicht (SL1), auf einem vernetzbaren Polymermaterial basierend, und die zweite Haftschicht (SL2), auf einem vernetzbaren Polymermaterial basierend, auf demselben vernetzbaren Polymermaterial basieren.

12. Verfahren nach einem der vorhergehenden Ansprüche, **dadurch gekennzeichnet, dass** die erste Haftschicht (SL1) auf einem vernetzbaren Polymermaterial in flüssigem Zustand basiert, und/oder dass die zweite Haftschicht (SL2) auf einem vernetzbaren Polymermaterial in flüssigem Zustand basiert.

## Claims

1. A method for manufacturing a photovoltaic module (10), comprising at least one photovoltaic cell (4) between a first transparent layer (1) forming a front face of the photovoltaic module (10) and a second layer (2) forming a rear face of the photovoltaic module (10), **characterised in that** it comprises:
1) a first step of depositing a first adhesive layer (SL1) based on a crosslinkable polymer material over the first layer (1) intended to form the front face of the photovoltaic module (10), and in depositing a second adhesive layer (SL2) based on a crosslinkable polymer material over the second layer (2) intended to form the rear face of the photovoltaic module (10),
2) a second step of carrying out a partial crosslinking of the two adhesive layers (SL1, SL2) based on a crosslinkable polymer material to form two partially crosslinked adhesive layers (SPR1, SPR2),
3) a third step of depositing said at least one photovoltaic cell (4) over one (SPR1) of the two partially crosslinked adhesive layers (SPR1, SPR2),
4) a fourth step of forming a multilayer stack (1, SPR1, 4, SPR2, 2) by assembling one (SPR1) of the two partially crosslinked adhesive layers (SPR1, SPR2) over the other one (SPR2) of the two partially crosslinked adhesive layers (SPR1, SPR2), which comprises said at least one photovoltaic cell (4),
5) a fifth step of carrying out the lamination of the multilayer stack (1, SPR1, 4, SPR2, 2), and the completion of the crosslinking of the two partially crosslinked adhesive layers (SPR1, SPR2),
the crosslinking rate implemented during the second step of partial crosslinking of the two adhesive layers (SL1, SL2) based on a crosslinkable polymer material being comprised between 40% and 70%.

2. The method according to claim 1, **characterised in that** each adhesive layer (SL1, SL2) based on a crosslinkable polymer material, deposited during the first step, has a thickness comprised between 20 and 100 µm, preferably between 20 and 60 µm, even preferably in the range of 50 µm.

3. The method according to claim 1 or 2, **characterised in that** the crosslinking rate implemented during the second step of partial crosslinking of the two adhesive layers (SL1, SL2) based on a crosslinkable polymer material is comprised between 50 % and 60%, even more preferably between 50% and 55%.

4. The method according to one of the preceding claims, **characterised in that** the crosslinking time implemented during the second step of partial crosslinking of the two adhesive layers (SL1, SL2) based on a crosslinkable polymer material is comprised between 1 minute and 1 hour.

5. The method according to any one of the preceding claims, **characterised in that** the crosslinking temperature implemented during the second step of partial crosslinking of the two adhesive layers (SL1, SL2) based on a crosslinkable polymer material is comprised between 50 and 150°C.

6. The method according to claims 4 and 5, **characterised in that** the crosslinking duration implemented during the second step of partial crosslinking of the two adhesive layers (SL1, SL2) based on a crosslinkable polymer material is comprised between 5 minutes and 15 minutes, and **in that** the crosslinking temperature implemented during the second step of partial crosslinking of the two adhesive layers (SL1, SL2) based on a crosslinkable polymer material is comprised between 90 and 110°C.

7. The method according to any one of the preceding claims, **characterised in that** the fifth lamination step is carried out at a positive pressure comprised between 100 mbar and 1 bar, in particular between 500 mbar and 1 bar, still in particular between 800 mbar and 1 bar.

8. The method according to any one of the preceding claims, **characterised in that** the fifth lamination step comprises a pump-out for a duration comprised between 5 and 10 minutes.

9. The method according to any one of the preceding claims, **characterised in that** the crosslinkable polymer material is selected from the family of silicones.

10. The method according to any one of the preceding claims, **characterised in that** the said at least one photovoltaic cell (4) can be selected from among silicon-type cells, III-V semiconductors, CIGS (copper, indium, gallium, selenium), CdTe (cadmium telluride), organics, perovskites or multi-junctions of these types.

11. The method according to any one of the preceding claims, **characterised in that** the first adhesive layer (SL1) based on a crosslinkable polymer material and the second adhesive layer (SL2) based on a crosslinkable polymer material are based on the same crosslinkable polymer material.

12. The method according to any one of the preceding claims, **characterised in that** the first adhesive layer (SL1) is based on a crosslinkable polymer material in the liquid state and/or **in that** the second adhesive layer (SL2) is based on a crosslinkable polymer material in the liquid state.
